Europäisches Patentamt

European Patent Office

Office européen des brevets

(11) Publication number: **0 466 326 A1**

# EUROPEAN PATENT APPLICATION

(21) Application number: **91305157.9**

(22) Date of filing: **07.06.91**

(51) Int. Cl.⁵: **H05K 9/00**

(30) Priority: **13.06.90 US 537546**

(43) Date of publication of application:
**15.01.92 Bulletin 92/03**

(84) Designated Contracting States:
**DE ES FR GB**

(71) Applicant: **CHOMERICS, INC.**
**77 Dragon Court**
**Woburn Massachusetts 01888(US)**

(72) Inventor: **Hayden, James**
**61 Bayside Road**
**Greenland, New Hampshire 03840(US)**

(74) Representative: **Barlow, Roy James et al**
**J.A. KEMP & CO. 14, South Square, Gray's Inn**
**London WC1R 5LX(GB)**

(54) **End termination for gasket clips and process for making the same.**

(57) A clip-on gasket having a U-shaped clip and a gasket attached to one or both of the arms of the clip. The clip is formed by a process wherein the metal blank, from which the clip is formed, is notched such that one only needs to cut through one arm of the clip and the gasket in order to obtain a clip-on gasket of desired length.

FIG. 1

This invention relates an end termination for gasket clips. More particularly, it relates to an end termination for EMI/RFI gasket clips formed by a roll forming process. Lastly, it relates to an improved method for making such an end termination on a gasket clip.

## BACKGROUND OF THE INVENTION

Clip-on gaskets are well known devices for holding a gasket or seal in a desired position, particularly on a thin metal edge, such as a metal cabinet door. The clip device generally is formed from a piece of flat metal stock and bent into a clip configuration by well known metal processes such as roll forming. A gasket is generally attached to the clip by a crimping or clinching edge along one of the surfaces of the clip device or by adhesive or a vulcanization process. While generally acceptable, this clip-on gasket has several drawbacks.

As the clip-on gasket is generally formed in long lengths, it is then custom cut into shorter more desirable lengths. In doing so, however, one must cut not only through the entire roll formed metal clip, which can constitute two or more layers of metal, but one must also cut through the attached gasket. Due to the thickness of the clip-on gasket and the different properties of the gasket or seal and the metal clip, obtaining a clean cut is not always possible. Hand finishing of the cut end is required to debur the metal end, to smooth off and/or seal the gasket end and to ensure that the gasket is retained on the clip. Moreover, when the gasket or seal has an outer covering of fabric, wire mesh or a plastic film, obtaining a clean cut is even more difficult. In particular, with fabrics or wire mesh, the cut ends tend to unravel a portion of the fabric or mesh which must then be trimmed and stabilized so as to prevent further unraveling.

There is a need in the industry for a clip-on gasket that eliminates most if not all of these problems. The present invention provides such a gasket and process of making such a gasketed clip.

## SUMMARY OF THE INVENTION

The claimed invention relates to a clip-on gasket assembly formed of a roll formed metal clip which has been preblanked to create a notch so that only one layer of metal needs to be cut when the gasket is cut to its desired length. The process for forming such a clip is to create a notch at a desired location along a length of metal blank, then form the metal blank into the desired clip configuration, place and retain a gasket on one surface of the formed metal clip and cut the clip-on gasket at the desired location.

## IN THE DRAWINGS

Figure 1 is a view from about the clip-on gasket of the present invention.

Figure 2 shows a preferred embodiment of a metal blank with a notch formed in its surface.

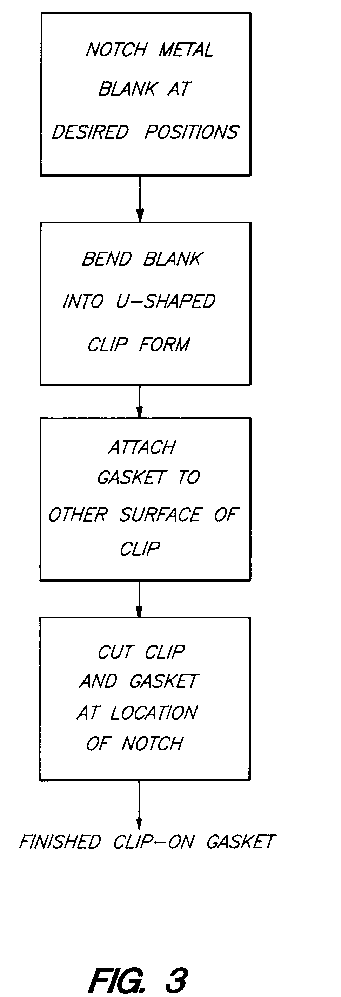

Figure 3 is a block diagram of the process for forming a clip-on gasket according to the present invention.

## DETAILED DESCRIPTION OF THE INVENTION

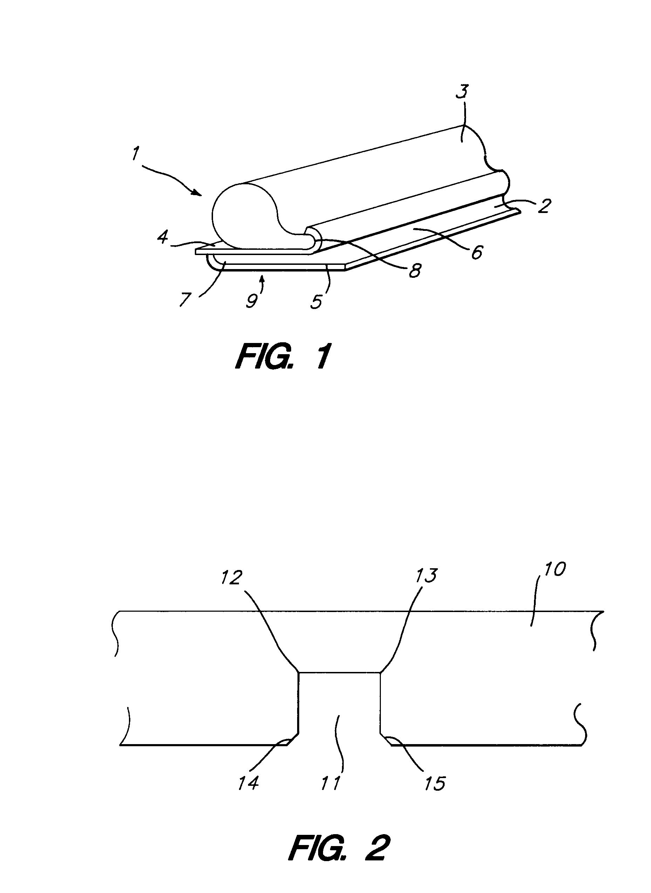

In Figure 1 is a preferred embodiment of the present invention. A clip-on gasket 1 is formed of a metal clip 2 and a gasket 3 attached to the clip 2. The clip 2 is generally of a U-shaped cross section having a first arm 4 and a second arm 5. Preferably, at least the arm upon which the gasket is attached has a broad flat portion upon which the gasket lies. If desired, both arms may be substantially flat. The gasket 3 in this embodiment is attached to an outer surface of the first arm 4. The clip 2 being U-shaped has an open end 6 and a closed end 7. The closed end being the portion that interconnects the two arms.

As can be seen from the drawing, the first arm 4 is preferably of greater length than the second arm 5, although if desired the two arms can be of substantially the same length. An attachment means such as a crimping edge 8 may also be formed on the arm of the clip upon which the gasket is mounted. A crimping edge 8 can be formed by bending an outer portion of an arm back upon itself, in essence forming a second smaller U-shaped configuration in the arm. A portion of the gasket is then placed into crimping edge, a crimp is then put upon the edge 8 and the portion of the gasket 3 in the edge 8 to hold the gasket securely in place.

The clip 2 has two ends, one end 9 is shown in Figure 1.

As described above, in one embodiment the first arm 4 is of a length greater than that of the second arm 5. In this embodiment, this is true for both ends of the clip. This end termination means is formed by a notching process described in more detail below. However, in essence the clip-on gasket before it is cut to the desired length has had at least the portion of the second arm removed so as to make the cutting and finishing of the clip-on gasket easier and to provide an improved product. Preferably, the closed end portion of the clip is also removed by the notching process so that only the gasket 3, the first arm 4 and, if used, the crimping edge 8 are cut to complete the clip-on gasket.

Alternatively, both arms can be of the same length so long as the cut is made on the clip-on gasket a point substantially above that of the side edge of the notch.

The clip 2 of the present invention is made of metal, preferably a thin gauge of metal that allows for easy beding of the metal blank into a clip configuration. Suitable metals include but are not limited to steel, stainless steel, copper, beryillium copper and aluminum. Other suitable metals would be well known to one skilled in the art.

The gasket used on the clip is not critical to the invention. However, a preferred embodiment is to use the clip-on gasket to shield against stray electro-magnetic or radio frequency energy, often referred to as EMI/RFI (for electromagnetic interference and/or radio frequency interference).

In EMI/RFI applications the gasket must be electrically conductive and it must be in electrical continuity with the metal clip. Such gaskets are well known to one skilled in the art. These gaskets include solid wire mesh gaskets, wire mesh covered elastomeric core gaskets such as a wire mesh wrapped or knitted around a silicone rubber core, a solid or hollow elastomeric gasket which is filled with an electrically conductive material such as carbon black, silver and other conductive metals, coated fillers such as silver coated copper particles, silver coated glass or silver coated plastic or a coated gasket having such a filler in the outer coating. The amount of conductive filler should be sufficient to provide EMI/RFI shielding properties.

If desired, the gasket, whether for EMI/RFI applications or not, can have a retention means, such as a tail or flat extension or leg which can be secured to the clip by a crimping edge or other such means. Figure 1 shows such a crimping edge and as discussed later on, other alternative means for attachment may be used.

The clip-on gasket may also contain other features that are commonly found on such clips. For instance, the clip may be a series of teeth or prongs formed on one or both of its arms to retain the clip to its mounting surface and to ensure good electrical continuity to the mounting surface when the clip-on gasket is used in EMI/RFI applications. In those instances, the teeth or prongs scrape through any paint, oxide or other coating on the mounting substrate and establish a good electrical contact between the clip and the substrate.

Additionally, one or both of the outer edges of the clip closest to the open end may be bent slightly away from each other and the planes of the two arms to form a divergent opening for easy attachment of the clip to the substrate.

Further, one of the arms may contain a bent portion along its length such that the arm curves toward and then away from the other arm. This forms a restriction through which the substrate must pass and ensures a strong attachment of the clip to the substrate.

Likewise, if desired, one of the two arms may be of a width greater than the other so that the longer arm may aid in the attachment of the clip-on gasket to a substrate.

A process for making a clip-on gasket of the present invention is to take a blank of suitable metal such as steel, including stainless steel, aluminum, copper, beryllium copper or any other metal commonly used in forming such clips and forming a notch in the blank at a desired position in the blank. Figure 2 shows a blank 10 having such a notch 11 formed in it. The notch may have square edges, angled edge, rounded edges or mixtures thereof depending upon the end configuration that is desired to be achieved. In a preferred embodiment as shown in Figure 2 the inner edges 12 and 13 of the notch 10 are squared while the outer edges 14 and 15 adjacent the outer edge of the blank are angled or rounded.

After the metal from the notch is removed, the blank is formed by one or more bending steps into a U-shaped clip. Preferably, the clip is formed by a roll forming process. If desired a crimping edge is formed on one of the two arms of the U-shaped clip to retain the gasket. This crimping edge is a portion of the arm that is bent back upon itself in a U-shaped configuration.

The gasket is then placed on an outer surface of one of the arms of the U-shaped clip and attached to that surface. In those embodiments having the crimping edge described above, the gasket is mounted on the arm having the crimping edge and preferably has a retention means such as an arm or other extension that is retained within the crimping edge. In other embodiments where no crimping edge is used, the gasket may be bonded to the outer surface of the arm by an adhesive, by self vulcanization (cured or vulcanized in place) by a mechanical means such as a rivet or screw, or by any other suitable retaining means known to one skilled in the art.

The clip-on gasket having been formed is now cut at the location of the notch to form a clip-on gasket of a desired length.

If desired, additional steps may be performed to the finished clip-on gasket. For example, the ends may be dipped into or coated with a material such as a silicone or epoxy resin to seal the ends. Alternatively, end caps or heat shrunk end bands may be placed on the ends of the clip and secured in place.

In another embodiment of the present invention, the edge portion of the notch between the inner edges 12 and 13 and the outer edges 14 and 15 may be at an angle, such as of 45ü so that a

miter joint is formed. If desired, the upper arm and gasket may also be cut along that miter. This configuration is especially useful in applications such as cabinet doors which are rectangular in shape and require a clip-on gasket around their entire periphery.

The present invention and the process of making such a clip-on gasket provides many benefits. It provides improved retention of the gasket to the clip and it prevents the jaw or opening of the clip from collapsing as is commonly encountered when cutting through the entire U-shaped section of the clip. Moreover, it provides a clean edge on the end portion of the clip which requires little or no deburring after the gasket has been cut to length. Additionally, it has been found that one is able to maintain tighter control over the length of the clip-on gasket than was possible with the conventional clip-on gasket. In part, it is believed that the notching of the blank reduces waste and trimming which allows for more accurate lengths to be made.

The present invention is particularly useful for EMI/RFI gaskets as has been discussed more fully herein. However, it is useful with any clip-on type of gasket, such as may be used for weather-stripping, padding, etc. in the automotive, construction and other industries.

While the present invention has been described invention to its preferred embodiments, other embodiments can achieve the same result. Variations and modifications of the present invention will be obvious to one skilled in the art and it is intended to cover in the appended claims all such modifications and equivalents as fall within the true spirit and scope of the invention.

## Claims

1. A clip-on gasket comprising a metal clip which has a generally U-shaped cross section formed of a first arm and a second arm, and having an open and closed edge, and having two ends which are formed by notching a blank from which the metal clip is formed, and a gasket mounted to an outer surface of one of the arms.

2. The clip-on gasket of Claim 1 wherein the ends of the clip have an angled or rounded portion adjacent the open edge of the clip.

3. The clip-on gasket of Claim 1 wherein the gasket is an electrically conductive gasket having shielding capabilities sufficient for EMI/RFI shielding.

4. A clip-on gasket having an improved end termination comprising a metal clip of a generally U-shaped cross section, the clip having a closed end, defining the bottom of the U-shaped cross section, an open end defining the top of the U-shaped cross section, a first arm and a second arm defining the linear portions of the U-shaped cross section and being connected to the closed end of the clip, a gasket attached to one of the first and second arms of the clip and a first and second end of the clip at the respective terminations of the length of the length of the clip, the ends having been formed by notching one of the arms of the clip before or during the formation of the clip so that only one arm and the gasket have to be cut in forming the gasket to its desired length.

5. A clip-on gasket comprising a metal clip having a U-shaped cross section of a closed end, an open end and a first and second arm, the clip being formed by notching a metal blank at predetermined location such that metal is removed from at least one arm of the clip, but metal is not removed entirely from the other arm of the clip, a gasket mounted to a broad flat surface on of the arm which is not notched, the gasket and arm are then cut at the location of the notch so as to form an end to the clip.

6. A process of forming a clip-on gasket comprising the steps of:
   a) forming a notch at a predetermined position in a metal blank wherein the metal blank has a length greater than its width, said notch being formed over a substantial portion of the width of the blank, but less than the entire width of the blank;
   b) forming the blank into a U-shaped clip having two arms;
   c) attaching a gasket or seal to an outer surface of one of the arms of the U-shaped clip; and
   d) cutting through the remaining blank and the gasket at the location of the notch.

7. The process of Claim 6 wherein the gasket is attached to the clip by a crimping edge formed on an outer portion of the arm upon which the gasket is attached.

8. The process of Claim 6 wherein the gasket is attached to the outer surface of the arm by vulcanization.

9. The process of Claim 6 wherein the notch has angled edges along the edge of the blank where the notch is formed.

**10.** A clip-on gasket made by the process according to Claim 6.

FIG. 1

FIG. 2

```
┌─────────────────────┐
│    NOTCH METAL      │
│     BLANK AT        │
│  DESIRED  POSITIONS │
└─────────────────────┘
           │
           ▼
┌─────────────────────┐
│     BEND BLANK      │
│   INTO U-SHAPED     │
│     CLIP FORM       │
└─────────────────────┘
           │
           ▼
┌─────────────────────┐
│      ATTACH         │
│    GASKET TO        │
│  OTHER SURFACE OF   │
│       CLIP          │
└─────────────────────┘
           │
           ▼
┌─────────────────────┐
│     CUT CLIP        │
│   AND GASKET        │
│   AT LOCATION       │
│    OF NOTCH         │
└─────────────────────┘
           │
           ▼
   FINISHED CLIP-ON GASKET
```

*FIG. 3*

European
Patent Office

# EUROPEAN SEARCH REPORT

Application Number

**EP 91 30 5157**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | WO-A-8 601 069 (SEL)<br>* page 4, lines 14-25; page 7, lines 10-14; figure 2 *<br>– – – | 1-7 | H 05 K 9/00 |
| Y | US-A-4 652 695 (R.B. BUSBY)<br>* column 3, lines 42-52; column 4, lines 43-62; figure 5 *<br>– – – | 1-7 | |
| A | US-A-4 866 213 (T.E. LINDSAY)<br>* column 1, lines 48-66; column 2, line 60 - column 3, line 11; figures 4-6 *<br>– – – – – | 1-5 | |
| | | | **TECHNICAL FIELDS SEARCHED (Int. Cl.5)** |
| | | | H 05 K 9/00<br>H 05 K 5/00 |

The present search report has been drawn up for all claims

| Place of search | Date of completion of search | Examiner |
|---|---|---|
| Berlin | 24 September 91 | ALEXATOS G |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document